# EUROPÄISCHE PATENTSCHRIFT

(11) **EP 0 806 491 B1**
(45) Veröffentlichungstag und Bekanntmachung des Hinweises auf die Patenterteilung: **16.01.2002**
(21) Anmeldenummer: 97107372.1
(22) Anmeldetag: 05.05.1997
(51) Int. Cl.: C23C 14/50

(54) **Verfahren zum Aufdampfen von Vergütungsschichten auf optische Substrate**
Vapor deposition method for coating optical substrates
Procédé de dépôt en phase vapeur pour revêtement de substrates optiques

(30) Priorität: 10.05.1996 CH 119996
(43) Veröffentlichungstag der Anmeldung: 12.11.1997
(73) Patentinhaber: Satis Vacuum Industries Vertriebs - AG, 8700 Küsnacht (CH)
(72) Erfinder: Suter, Rudolf, 6048 Horw (CH)
(74) Vertreter: Petschner, Goetz

(56) Entgegenhaltungen:
- DE-A- 1 913 318
- US-A- 3 396 696
- US-A- 4 817 559
- PATENT ABSTRACTS OF JAPAN vol. 007, no. 232 (C-190), 14.Oktober 1983 & JP 58 123868 A (FUJITSU KK), 23.Juli 1983,
- PATENT ABSTRACTS OF JAPAN vol. 007, no. 209 (C-186), 14.September 1983 & JP 58 107484 A (OLYMPUS KOGAKU KOGYO KK), 27.Juni 1983,

## Beschreibung

Die vorliegende Erfindung betrifft ein Verfahren zum Aufdampfen von Vergütungsschichten auf Flächen optischer Substrate, wie Kunststoff-Brillengläser, welche auf Trägermittel aufspannbar sind, die sich in einem evakuierbaren Rezipienten oberhalb oder unterhalb von auswechselbaren Verdampfungsquellen befinden.

Durch die US 4817559 A ist bereits ein Verfahren zum Aufdampfen von mindestens einer Oberflächenschicht auf optische Substrate, insbesondere Brillengläser, im Vakuum, bekannt, bei dem eine vorgegebene Anzahl solcher Substrate nach dem Aufdampfen von in der Regel mehreren Schichten aus der Ebene, in welcher die Substratflächen der Wirkung der auswechselbaren Verdampfungsquellen ausgesetzt waren, gruppenweise mittels kalottenförmiger Trägermittel herausbewegt und nochmals eine gleiche Anzahl Substratflächen in diese Ebene hineinbewegt, um diese ebenfalls nachfolgend einmal oder mehrmals zu bedampfen, m. a. W. werden zunächst auf den Substratflächen der einen Seite der Substrate die einzelnen Vergütungsschichten nacheinander aufgedampft, dann die Substrate gewendet und dann die anderen Substratflächen bedampft.

Solche Verfahren sind aber wegen der Wendeträgheit solcher kalottenförmiger Trägermittel sehr umständlich, da nach jedem Bedampfungsvorgang für ein sehr langsam erfolgendes Wenden der Substrate resp. für das Einsetzen einer neuen Quelle für eine neue Vergütungsschicht die Verdampfungsquelle abgeschaltet werden muss.

Zudem besteht durch das vielmalige Aufheizen der Verdampfungsquellen, welche beispielsweise Elektronenstrahl-Verdampfer oder widerstandsbeheizte thermische Verdampfer sein können, die Gefahr einer Zersetzung der Aufdampfmaterialien sowie der Suboxyd-Bildung und der daraus resultierenden Brechwert-Änderungen.

Es ist deshalb Aufgabe der vorliegenden Erfindung, ein Verfahren der vorgenannten Art zu schaffen, bei dem die vorgenannten Nachteile vermieden werden.

Dies wird beim Verfahren zum Aufdampfen von Vergütungsschichten auf Flächen optischer Substrate, wie Kunststoff-Brillengläser, welche auf Trägermittel aufspannbar sind, die sich in einem evakuierbaren Rezipienten oberhalb oder unterhalb von auswechselbaren Verdampfungsquellen befinden, erfindungsgemäss dadurch erreicht, dass jeweils innerhalb eines Bedampfungsvorganges zur Erzeugung einer Vergütungsschicht zunächst die der Verdampfungsquelle zugewendeten Flächen der auf Trägermittel aufgespannten Substrate bedampft und dann, alle Trägermittel mit den Substraten gleichzeitig und ohne Unterbrechung des Aufdampfstromes resp. ohne Stillsetzung der Verdampfungsquelle rasch gewendet und die nun der Verdampfungsquelle zugewendeten Flächen der Substrate ebenfalls bedampft werden, wonach ein zyklisches Auswechseln von Verdampfungsquellen erfolgt zum Aufbringen jeweils einer weiteren Vergütungsschicht auf die Substratflächen innerhalb eines neuen Bedampfungsvorganges.

Durch diese Massnahmen wird nun das zyklische Auswechseln der Verdampfungsquellen um die Hälfte reduziert und damit auch deren Aufheizung, was wiederum die Gefahr einer Zersetzung der Aufdampfmaterialien sowie der Suboxyd-Bildung und der daraus resultierenden Brechwert-Änderungen wesentlich verringert.

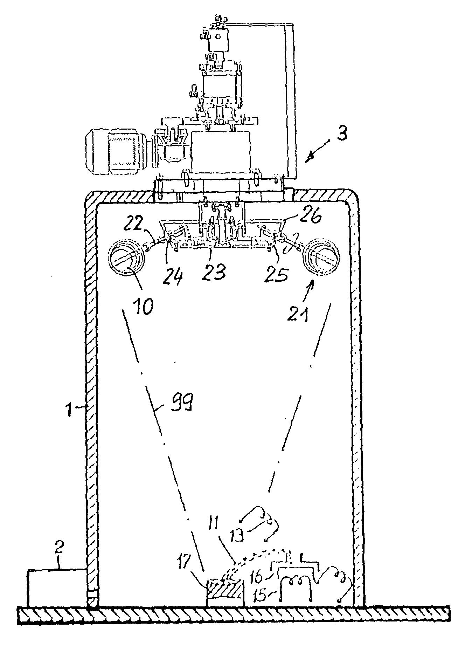

Das erfindungsgemässe Verfahren ist nachfolgend anhand der Zeichnung, welche im Längsschnitt in schematischer, vereinfachter Darstellung eine Vakuum-Beschichtungsanlage zum Bedampfen mehrerer optischer Substrate auf einer Wendeträger-Vorrichtung zeigt, näher erläutert.

Die veranschaulichte Vakuum-Beschichtungsanlage zum Aufdampfen von Vergütungsschichten auf optische Substrate, beispielsweise hier Kunststoff-Brillenglaser 10, umfasst einen, über eine Vakuum-Pumpe 2 evakuierbaren Rezipienten 1.

Im oberen Kammerbereich dieses Rezipienten 1 befindet sich eine Wendeträger-Vorrichtung 3 mit einer Mehrzahl, hier zwei erkennbare radial um eine kreisförmige Trägerplatte 23 angeordnete Wendeträger 21, die je an einer, temporär um 180° verdrehbaren Drehachse 22 abgestützt sind, wobei jeder Wendeträger 21 Mittel zum klemmenden Festhalten eines beidseitig zu beschichtenden Substrates oder zum Festhalten von zwei einseitig zu beschichtenden Substraten umfasst (nicht gezeigt).

Im unteren Bereich des Rezipienten 1 ist eine Verdampfungsquelle 100 angedeutet, die hier eine sogenannte Elektronenstrahlkanone mit einem Heizfaden 15 umfasst, dessen austretende Elektronen nach seiner Erhitzung in einer Fokussierungseinrichtung 16 strahlenförmig gebündelt werden. Beispielsweise kann der Elektronenstrahl von einer an negativer Hochspannung liegenden Wolframkathode erzeugt und mit einem geformten Wehnelt-Zylinder vorfokussiert werden. Dieser Elektronenstrahl lässt sich nun durch Umlenkmagnetmittel 13 in einen Tiegel 17 umlenken, in dem sich das Aufdampfmaterial befindet.

Da der Aufbau und die Funktionsweise solcher Vakuumaufdampfanlagen weiters soweit bekannt sind, erübrigt sich eine nähere Konstruktionsbeschreibung.

Wesentlich ist hier zunächst, dass an den Wendeträgern 21 resp. Drehachsen 22 Wendemittel zum gleichzeitigen Wenden aller Wendeträger angreifen.

Hierfür umfassen die Wendemittel einen von der Trägerplatte 23 umfänglich abragenden Zahnkranz 25, in den je ein Mitnahmezahnrad 24 eingreift, das mit der Drehachse 22 der Wendeträger 21 sowie mit einem weiteren, temporär verdrehbaren Gegenzahnkranz 26 in Wirkungsverbindung steht.

Damit ist es möglich, zu geeigneter Zeit den Gegenzahnkranz 26 relativ zum Zahnkranz 25 soweit zu verdrehen, bis die Wendeträger 21 mit ihren Substraten über das jeweilige Mitnahmezahnrad 24 um 180° gedreht sind. Dies erfolgt in Bruchteilen einer Sekunde, also so schnell, dass der Bedampfungsstrahl 99 nicht unterbrochen werden muss.

Eine solche Einrichtung gestattet, dass erfindungsgemäss jeweils innerhalb eines Bedampfungsvorganges zur Erzeugung einer Vergütungsschicht zunächst die der Verdampfungsquelle zugewendeten Flächen der auf Trägermittel aufgespannten Substrate bedampft und dann, ohne Stillsetzung der Verdampfungsquelle, die Trägermittel mit den Substraten rasch gewendet und die nun der Verdampfungsquelle zugewendeten Flächen der Substrate ebenfalls bedampft werden, wonach ein zyklisches Auswechseln von Verdampfungsquellen erfolgt zum Aufbringen jeweils einer weiteren Vergütungsschicht auf die Substratflächen innerhalb eines neuen Bedampfungsvorganges.

Durch diese Massnahmen wird nun das zyklische Auswechseln der Verdampfungsquellen um die Hälfte reduziert und damit auch deren Aufheizung, was wiederum die Gefahr einer Zersetzung der Aufdampfmaterialien sowie der Suboxyd-Bildung und der daraus resultierenden Brechwert-Änderungen wesentlich verringert.

## Patentansprüche

1. , Verfahren zum Aufdampfen von Vergütungsschichten auf Flächen optischer Substrate, wie Kunststoff-Brillengläser, welche auf Trägermittel aufspannbar sind, die sich in einem evakuierbaren Rezipienten oberhalb oder unterhalb von auswechselbaren Verdampfungsquellen befinden,
wobei
jeweils innerhalb eines Bedampfungsvorganges zur Erzeugung einer Vergütungsschicht zunächst die der Verdampfungsquelle zugewendeten Flächen der auf Trägermittel aufgespannten Substrate bedampft werden und
wobei dann
alle Trägermittel mit den Substraten gleichzeitig und ohne Unterbrechung des Aufdampfstromes resp. ohne Stillsetzung der Verdampfungsquelle in Sekundenbruchteilen gewendet und die nun der Verdampfungsquelle zugewendeten Flächen der Substrate ebenfalls bedampft werden,
wonach ein zyklisches Auswechseln von Verdampfungsquellen erfolgt zum Aufbringen jeweils einer weiteren Vergütungsschicht auf die Substratflächen innerhalb eines neuen Bedampfungsvorganges.

## Claims

1. Method for vapour deposition of coating layers on surfaces of optical substrates, such as synthetic material spectacle lenses, which can be clamped on support means which are disposed in a receptacle able to be evacuated and above or below the exchangeable evaporation sources, wherein within a vaporisation process for generation of a coating layer in each case initially the surfaces, which are turned towards the vaporisation source, of the substrates clamped on the support means are vapour deposited and wherein then all support means together with the substrates are turned simultaneously, and without interruption of the vapour deposition current or stopping of the vaporisation source, in fractions of a second and the surfaces, which are now turned towards the vaporisation source, of the substrates are similarly vapour deposited, whereafter a cyclic exchange of vaporisation sources takes place for the application in each case of a further coating layer on the substrate surfaces within a new vapour deposition process.

## Revendications

1. Procédé de dépôt en phase vapeur de couches de revêtement sur des faces de substrats optiques, comme des verres de lunettes en matière synthétique qui peuvent être tendus sur des moyens de support qui se trouvent dans un récipient apte à être évacué au-dessus ou en dessous de sources d'évaporation échangeables, où à chaque fois pendant une opération de vaporisation pour produire une couche de revêtement, d'abord les faces orientées vers la source de vaporisation des substrats tendus sur des moyens de support sont vaporisés et où ensuite tous les moyens de support sont retournés avec les substrats ensemble et sans interrompre le flux de vaporisation respectivement sans arrêter la source de vaporisation en des fractions de seconde, et les faces des substrats orientées maintenant vers la source de vaporisation sont également vaporisées, à la suite de quoi a lieu un échange cyclique des sources de vaporisation pour appliquer respectivement une autre couche de revêtement sur les faces de substrat pendant une nouvelle opération de vaporisation.
